# EUROPÄISCHE PATENTSCHRIFT

(11) **EP 3 467 944 B1**
(45) Veröffentlichungstag und Bekanntmachung des Hinweises auf die Patenterteilung: **01.12.2021**
(21) Anmeldenummer: 17195471.2
(22) Anmeldetag: 09.10.2017
(51) Int. Cl.: H01R 9/03, H01R 4/02, H01R 13/66, H02G 15/18, H01R 13/719, H01R 4/70

(54) **ELEKTRISCHES KABEL**
ELECTRIC CABLE
CÂBLE ÉLECTRIQUE

(43) Veröffentlichungstag der Anmeldung: 10.04.2019
(73) Patentinhaber: MD Elektronik GmbH, 84478 Waldkraiburg (DE)
(72) Erfinder: HUBER, Martin, 83119 Obing (DE)
(74) Vertreter: Maikowski & Ninnemann Patentanwälte Partnerschaft mbB

(56) Entgegenhaltungen:
- EP-A1- 2 541 697
- WO-A1-92/17922
- US-A- 4 710 593
- US-A1- 2004 110 421

## Beschreibung

Die Erfindung betrifft ein elektrisches Kabel nach dem Oberbegriff des Anspruchs 1, insbesondere in Form eines Kabels für die Datenübertragung in Kraftfahrzeugen.

Ein derartiges elektrisches Kabel umfasst mindestens zwei Adern, die nebeneinander entlang einer Kabellängsrichtung verlaufen, sowie eine Isolierung, mittels der die Adern elektrisch voneinander isoliert sind, und weiterhin ein elektrisches Bauelement, das mit den Adern jeweils in elektrischem Kontakt steht. Hierbei kann die elektrische Isolierung der Adern beispielsweise dadurch gebildet sein, dass jede der Adern in bekannter Weise von einer isolierenden Hülle umgeben ist.

Ein derartiges elektrisches Kabel mit einem integrierten elektrischen Bauelement ist beispielsweise aus der WO 2017/199136 A1 bekannt.

Die Integration eines elektrischen Bauelementes in ein elektrisches Kabel hat den Vorteil, dass hiermit unmittelbar am Kabel selbst zusätzliche Funktionen, wie etwa eine Filterung von Signalen, vorgenommen werden können.

In der WO 92/17922 A1 ist eine starre Leitung beschrieben, die zwei Leitungsabschnitte umfasst, welche über ein Verbindungsglied miteinander verbunden sind. Das Verbindungsglied weist Durchgänge für elektrische Verbindungselemente auf, über die die Leiter der beiden Leitungsabschnitte elektrisch miteinander kontaktiert werden.

Aus der US-A 4,710,593 ist ein Kabel bekannt, in das eine elektrische Leiterplatte mit darauf angeordneten Leiterbahnen integriert ist. Und die US 2004/0110421 A1 zeigt ein Schaltungsmodul in Form eines dünnen Filmes, dass ein elektrisches Bauelement, zum Beispiel in Form eines Equalizers, trägt.

Der Erfindung liegt das Problem zugrunde, ein mehradriges elektrisches Kabel der eingangs genannten Art weiter zu verbessern.

Dieses Problem wird erfindungsgemäß durch die Schaffung eines elektrischen Kabels mit den Merkmalen des Patentanspruchs 1 gelöst.

Danach ist bei einem gattungsgemäßen elektrischen Kabel weiterhin vorgesehen, dass das elektrische Bauelement auf der den Adern des Kabels zugewandten Innenseite eines flexiblen Trägers angeordnet ist, der die Adern im Querschnitt ringförmig umgibt (umschließt), wobei die Isolierung der Adern an der Stelle, an der das elektrische Bauelement angeordnet ist, teilweise beseitigt ist, um einen elektrischen Anschluss des elektrischen Bauelementes zu ermöglichen.

Durch die Anordnung des elektrischen Bauelementes auf einem flexiblen Träger, der die Adern des Kabels im Querschnitt ringförmig umgibt bzw. umschließt, lassen sich der Träger sowie das hierauf angeordnete elektrische Bauelement in einfacher Weise zwischen den hiervon umschlossenen Adern einerseits und etwa einem äußeren Kabelmantel oder einem gegebenenfalls vorhandenen Kabelschirm andererseits anordnen.

Der flexible Träger kann dabei neben dem elektrischen Bauelement selbst auch die elektrischen Anschlusselemente tragen, über die das elektrische Bauelement mit den Adern des elektrischen Kabels in Kontakt steht und die von dem elektrischen Bauelement beabstandet angeordnet sein können. Hierzu verlaufen an dem flexiblen Träger beispielsweise elektrische Leitungen, insbesondere in Form von Leiterbahnen, vom elektrischen Bauelement zu den zugehörigen elektrischen Anschlusselementen. Über jene elektrischen Anschlusselemente kann der flexible Träger an den Adern anliegen, um eine elektrische Verbindung herzustellen.

Der flexible Träger ist insbesondere hinreichend flexibel, um derart zusammenrollbar zu sein, dass er im zusammengerollten Zustand die Adern des elektrischen Kabels

(hinreichend eng) umschließt, derart, dass der flexible Träger zwischen jenen Adern und einer Umhüllung des Kabels, wie zum Beispiel einem Kabelschirm und/oder einen Kabelmantel, angeordnet sein kann.

Bei dem am flexiblen Träger angeordneten elektrischen Bauelement kann es sich insbesondere um ein Halbleiter-Bauelement handeln. Das elektrische Bauelement ist vorteilhaft ebenfalls flexibel, sodass es beim Rollen des flexiblen Trägers ebenfalls um die Adern herumgelegt werden kann. Da sich das elektrische Bauelement - entlang der Umfangsrichtung des im Querschnitt ringförmigen flexiblen Trägers betrachtet - regelmäßig nur über einen Teil der Ausdehnung des flexiblen Trägers (in Umfangsrichtung) erstreckt, also im Unterschied zum flexiblen Träger nicht über einen Winkel von 360° bzw. nahezu 360° zusammengerollt werden muss, kann das elektrische Bauelement gegebenenfalls eine geringere Flexibilität aufweisen als der zugehörige Träger.

Die elektrischen Anschlusselemente können z.B. als starre elektrische Verbindungsstellen ausgeführt sein, die von dem flexiblen Träger nach innen in Richtung auf die Adern des Kabels vorstehen. Es kann sich hierbei insbesondere um starre Erhebungen an der Innenseite des flexiblen Trägers handeln.

Gemäß einer Weiterbildung sind die elektrischen Anschlusselemente jeweils mit einem Durchgang versehen, der mit einer zugeordneten Durchgangsöffnung an dem flexiblen Träger fluchtet. Hierdurch kann der flexible Träger durch die Durchgänge der Anschlusselemente hindurch an den Adern des elektrischen Kabels festgelegt werden, und zwar insbesondere stoffschlüssig, zum Beispiel durch Löten oder Schweißen. Hierbei sichert die stoffschlüssige Verbindungsstelle gleichzeitig den elektrischen Kontakt zwischen einer jeweiligen Ader und dem zugehörigen Anschlusselement am flexiblen Träger.

Nach einer Ausführungsform der Erfindung sind für jede Ader des elektrischen Kabels, die von dem flexiblen Träger umschlossen ist und die mit dem am Träger angeordneten elektrischen Bauelement elektrisch kontaktiert sein soll, jeweils zwei entlang der Kabellängsrichtung voneinander beabstandete Anschlusselemente an dem flexiblen Träger vorgesehen, wobei jedes der beiden Anschlusselemente jeweils mit der zugehörigen Ader des elektrischen Kabels in elektrischem Kontakt steht.

Ferner kann vorgesehen sein, dass mindestens eine der Adern an der Stelle, an der das elektrische Bauelement sowie der zugehörige flexible Träger angeordnet sind, eine Unterbrechung aufweist, welche durch das elektrische Bauelement (sowie durch die am flexiblen Träger vorgesehenen elektrischen Leitungen, einschließlich der zugehörigen Anschlusselemente) überbrückt wird. Alternativ kann eine jeweilige Ader im Bereich des elektrischen Bauelementes sowie des zugehörigen flexiblen Trägers unterbrechungsfrei ausgeführt sein.

Um einen zuverlässigen elektrischen Anschluss des elektrischen Bauelementes an eine jeweilige Ader zu ermöglichen, ist letztere im Bereich des elektrischen Bauelementes zumindest teilweise von ihrer Isolierung befreit. An den abisolierten Bereichen einer jeweiligen Ader lässt sich unmittelbar der elektrische Kontakt mit den zugehörigen Anschlusselementen des flexiblen Trägers herstellen.

Die Isolierung einer jeweiligen Ader kann dabei an der Stelle, an der das elektrische Bauelement angeordnet ist, insbesondere über die Längsausdehnung des zugehörigen flexiblen Trägers (in Kabellängsrichtung), entfernt sein.

Weiterhin kann sich der flexible Träger nach innen an den Adern abstützen, und zwar insbesondere über die am Träger angeordneten Anschlusselemente an den abisolierten Bereichen der Adern abstützen.

Der flexible Träger kann derart ausgeführt und dimensioniert sein, dass er sämtliche Adern des elektrischen Kabels umschließt.

Der flexible Träger braucht sich entlang der Kabellängsrichtung lediglich so weit zu erstrecken, wie es erforderlich ist, um das elektrische Bauelement aufzunehmen (einschließlich der zugehörigen elektrischen Leitungen und Anschlusselemente, über welche die Kontaktierung der Adern des Kabels erfolgt). Dementsprechend ist die Längsausdehnung des flexiblen Trägers entlang der Kabellängsrichtung typischerweise klein verglichen mit der Länge des Kabels insgesamt. So kann die Längsausdehnung des flexiblen Trägers entlang der Kabellängsrichtung insbesondere weniger als 10 % der Länge des elektrischen Kabels entlang jener Richtung betragen.

Die Adern des elektrischen Kabels können außen von einem Kabelschirm und/oder einem Kabelmantel umgeben sein, wobei der flexible Träger innerhalb des vom Kabelmantel bzw. des vom Kabelschirm umschlossen Raumes liegt.

Weitere Einzelheiten und Vorteile der Erfindung werden bei der nachfolgenden Beschreibung von Ausführungsbeispielen anhand der Figuren deutlich werden.

Es zeigen:
- Figur 1A: eine Explosionsdarstellung eines mehradrigen elektrischen Kabels mit einem im Querschnitt ringförmig ausgeführten flexiblen Träger zur Aufnahme eines elektrischen Bauelementes;
- Figur 1B: einen Längsschnitt durch das elektrische Kabel aus Figur 1A;
- Figur 1C: eine perspektivische und teilweise durchscheinende Darstellung des elektrischen Kabels aus den Figuren 1A und 1B;
- Figur 1D: einen Querschnitt durch eine perspektivische Darstellung des elektrischen Kabels aus den Figuren 1A bis 1C;
- Figur 2A: eine perspektivische Darstellung des flexiblen Trägers aus den Figuren 1A bis 1D zusammen mit dem darauf angeordneten elektrischen Bauelement;
- Figur 2B: eine Querschnittsdarstellung der Anordnung aus Figur 2A;
- Figur 2C: einen Längsschnitt durch die Anordnung aus Figur 2A;
- Figur 2D: den flexiblen Träger aus Figur 2A in flach ausgerollter Form;
- Figur 3: eine schematische Schnittdarstellung eines Ausschnittes des flexiblen Trägers zusammen mit einem hieran angeordneten elektrischen Bauelement sowie zugehörigen Anschlusselementen, wobei der Schnitt derart geführt ist, dass er sowohl das elektrischen Bauelement als auch zwei zugehörige Anschlusselemente schneidet;
- Figur 4A: eine Abwandlung der Anordnung aus Figur 2A für einen zweiadrigen elektrischen Leiter;
- Figur 4B: einen Querschnitt durch die Anordnung aus Figur 4A;
- Figur 4C: einen Längsschnitt durch die Anordnung aus Figur 4A;
- Figur 4D: den flexiblen Träger aus Figur 4A in flach ausgerollter Form;
- Figur 5: eine erste Abwandlung des elektrischen Kabels aus den Figuren 1A bis 1D in einer Explosionsdarstellung;
- Figur 6A: eine zweite Abwandlung des elektrischen Kabels aus den Figuren 1A bis 1D;
- Figur 6B: eine weitere Darstellung des elektrischen Kabels aus Figur 6A;
- Figur 7A: eine perspektivische Explosionsdarstellung eines elektrischen Steckverbinders mit einem flexiblen Träger zur Aufnahme eines elektrischen Bauelementes;
- Figur 7B: eine perspektivische, teilweise durchscheinende Darstellung der Anordnung aus Figur 7A;
- Figur 8A: eine Abwandlung der Anordnung aus Figur 7A mit einem Steckverbinder für einen zweiadrigen elektrischen Leiter;
- Figur 8B: eine perspektivische, teilweise durchscheinende Darstellung der Anordnung aus Figur 8A;
- Figur 8C: einen perspektivischen Längsschnitt durch die Anordnung aus den Figuren 8A und 8B;
- Figur 8D: einen weiteren Längsschnitt durch die Anordnung aus den Figuren 8A und 8B;
- Figur 9: eine Anordnung gemäß Figur 3, jedoch für den Anschluss an einen elektrischen Steckverbinder.

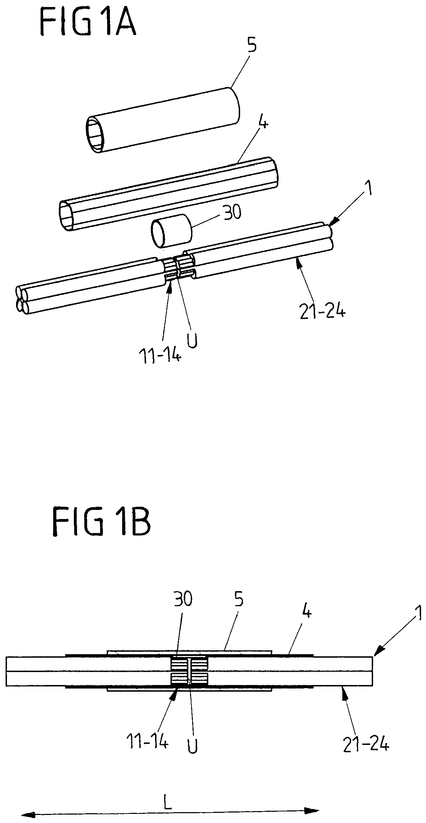

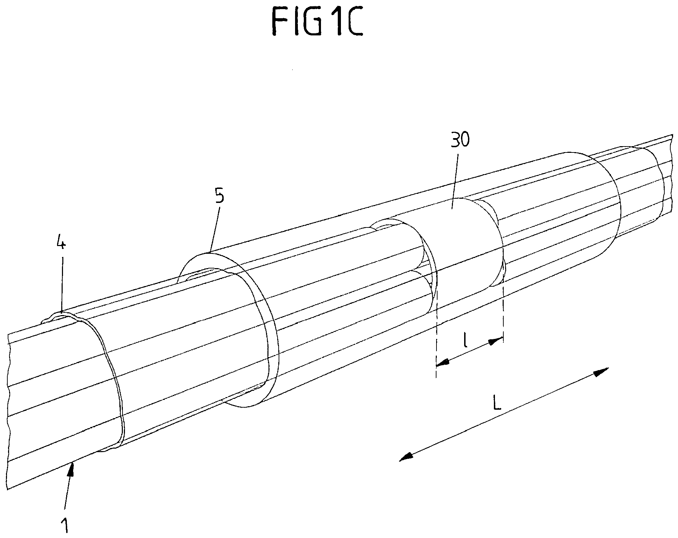

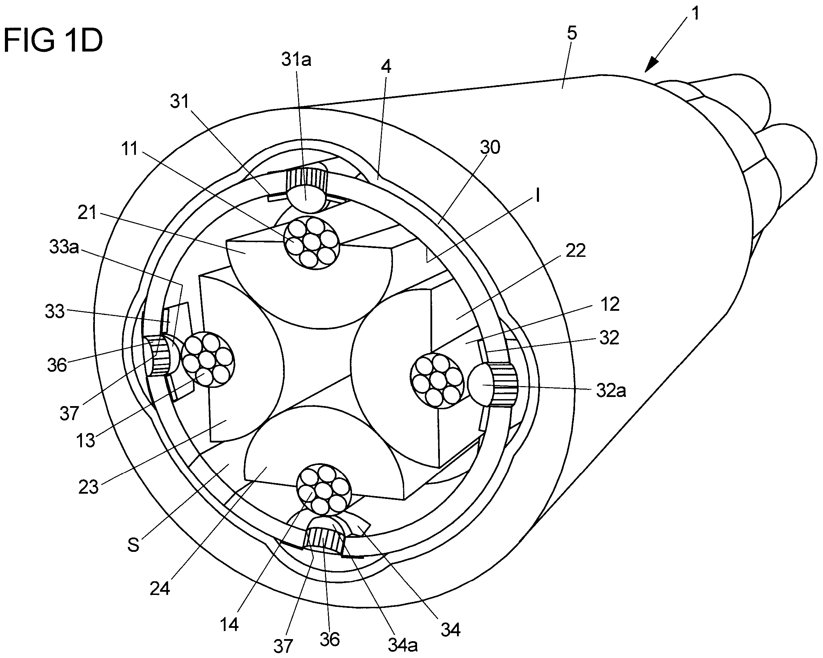

In den Figuren 1A bis 1D ist ein entlang einer Kabellängsrichtung L erstrecktes elektrisches Kabel 1 dargestellt. Das elektrische Kabel 1 umfasst eine Mehrzahl Adern 11, 12, 13, 14 (im Ausführungsbeispiel vier Adern), die nebeneinander entlang der Kabellängsrichtung L verlaufen. Die Adern 11, 12, 13, 14 des elektrischen Kabels 1 werden dabei im Ausführungsbeispiel jeweils durch eine Mehrzahl Litzen gebildet, die sich nebeneinander entlang der Kabellängsrichtung L erstrecken, vgl. Figur 1D. Die einzelnen Adern 11, 12, 13, 14 sind mittels einer Isolierung 21-24 elektrisch voneinander isoliert. Die Isolierung 21-24 wird dabei gebildet durch einzelne isolierende Hüllen 21, 22, 23, 24, von denen eine jede jeweils eine der Adern 11, 12, 13, 14 des elektrischen Kabels 1 umgibt und die zugehörige Ader 11, 12, 13, 14 hierdurch gegenüber der Umgebung isoliert.

In einem Teilbereich sind die Adern 11, 12, 13, 14 des elektrischen Kabels 1 von der Isolierung 21-24 befreit, sodass die Adern 11, 12, 13, 14 hier von außen, z.B. in radialer Richtung (quer zur Kabellängsrichtung L), elektrisch kontaktiert werden können. In dem abisolierten Bereich sind die Adern 11, 12, 13, 14 des elektrischen Kabels 1 von einem flexiblen Träger 30 umgeben, der die Adern 11, 12, 13, 14 im Querschnitt ringförmig umgibt (als eine Hülle umschließt). Im Ausführungsbeispiel hat der flexible Träger 30 konkret eine hohlzylindrische Form; er ist also im Querschnitt kreisringförmig ausgeführt.

Der flexible Träger 30 ist beispielsweise hinreichend flexibel, um derart zusammenrollbar zu sein, dass er im zusammengerollten Zustand die Adern 11, 12, 13, 14 des elektrischen Kabels 1 im Querschnitt ringförmig (hinreichend eng) umschließt, derart, dass der flexible Träger 30 zwischen jenen Adern 11, 12, 13, 14 und einer Umhüllung des Kabels 1, wie zum Beispiel einem Kabelschirm 4 und/oder einen Kabelmantel 5, angeordnet sein kann.

Die Ausdehnung I des flexiblen Trägers 30 in Kabellängsrichtung L ist dabei um ein Vielfaches kleiner als die entsprechende Länge des elektrischen Kabels 1; sie beträgt beispielsweise weniger als 10 % der Länge des Kabels 1 (in Kabellängsrichtung L).

Der flexible Träger 30 erstreckt sich quer zu der Kabellängsrichtung L von einem ersten freien Ende 30a zu einem zweiten freien Ende 30b. Er ist quer zu der Kabellängsrichtung L derart ringförmig zusammengerollt, dass die beiden freien Enden 30a, 30b einander gegenüber liegen. Zwischen den freien Enden 30a, 30b besteht dabei im Ausführungsbeispiel ein Spalt S; d.h., die freien Enden 30a, 30b sind in Umfangsrichtung des (zusammengerollten) flexiblen Trägers 30 voneinander beabstandet.

In dem vom flexiblen Träger 30 umgebenen abisolierten Bereich weisen die Adern 11, 12, 13, 14 des elektrischen Kabels 1 jeweils eine Unterbrechung U auf. D.h., eine jeweilige Ader 11, 12, 13, 14 ist in dem abisolierten Bereich in axialer Richtung (entlang der Kabellängsrichtung L) nicht durchgängig ausgeführt, sondern derart mit einer Unterbrechung U versehen, sodass an dieser Stelle kein direkter elektrischer Signal- bzw. Stromfluss entlang der jeweiligen Ader 11, 12, 13, 14 möglich ist.

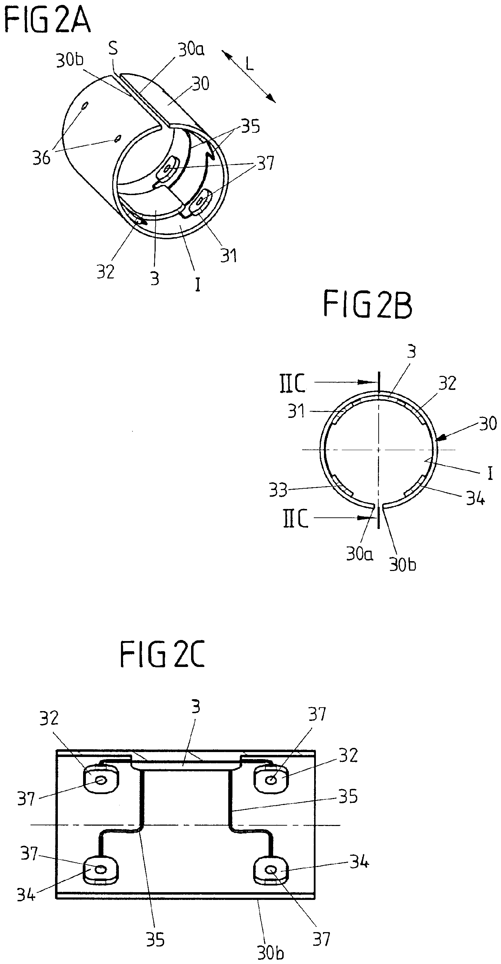

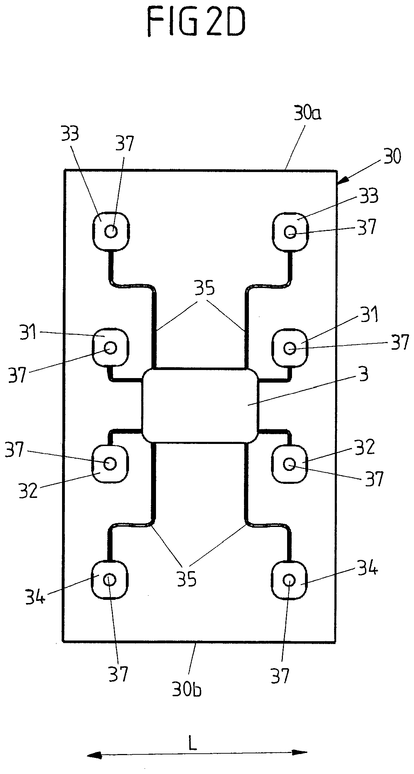

Auf der Innenseite des flexiblen Trägers 30, also auf der den Adern 11, 12, 13, 14 des elektrischen Kabels 1 zugewandten Seite, ist auf dem flexiblen Träger 30 ein elektrisches Bauelement 3 angeordnet, wie nachfolgend anhand der Figuren 2A bis 2D, insbesondere in Zusammenschau mit Figur 1D, näher beschrieben werden wird, wobei jenes elektrische Bauelement 3 mit den Adern 11, 12, 13, 14 des elektrischen Kabels 1 bzw. genauer mit deren abisolierten Bereichen, in elektrischem Kontakt steht. Bei dem elektrischen Bauelement kann es sich beispielsweise um einen Sensor, ein RFID-Element, ein ,,Bare Die" ("Nacktchip") oder um einen Filter handeln.

Die Adern 11, 12, 13, 14 des elektrischen Kabels, einschließlich des flexiblen Trägers 30, sind außen von einem Kabelschirm 4 umgeben, der beispielsweise durch eine elektrisch leitfähige Hülle, z.B. in Form einer elektrisch leitfähigen (metallischen) Folie, gebildet sein kann.

Die radial äußerste Schicht des elektrischen Kabels 1 wird gebildet durch einen Kabelmantel 5, der sowohl die Adern 11, 12, 13, 14 (mit der zugehörigen Isolierung 21-24) als auch den flexiblen Träger 30 sowie, soweit vorhanden, den Kabelschirm 4 hüllenartig umgibt und hierdurch das elektrische Kabel 1 nach außen abschließt.

Anhand der Figuren 2A bis 2D in Zusammenschau insbesondere mit Figur 1D wird nun die Anordnung des Bauelementes 3 am flexiblen Träger 30 sowie dessen Kontaktierung mit den Adern 11, 12, 13, 14 des elektrischen Kabels 1 näher beschrieben werden.

Gemäß den Figuren 2A bis 2D ist das elektrische Bauelement 3 auf dem flexiblen Träger 30 angeordnet (und zwar auf dessen dem Kabelinneren, also den Adern 11, 12, 13, 14 zugewandter Innenseite I). Von dem elektrischen Bauelement 3 gehen elektrische Leitungen 35 ab, insbesondere in Form auf dem flexiblen Träger 30 bzw. konkret auf dessen Innenseite I angeordneter Leiterbahnen. Die elektrischen Leitungen 35 verbinden das elektrische Bauelement 3 elektrisch mit elektrischen Anschlusselementen 31, 32, 33, 34, über die das elektrische Bauelement 3 mit den Adern 11, 12, 13, 14 des elektrischen Kabels 1 in elektrischen Kontakt bringbar ist bzw. im montierten Zustand in elektrischem Kontakt steht.

Konkret sind jeder der (vier) Adern 11, 12, 13, 14 des elektrischen Kabels 1 an dem flexiblen Träger 30 jeweils zwei elektrische Anschlusselemente 31; 32; 33; bzw. 34 zugeordnet, die jeweils entlang der Kabellängsrichtung L voneinander beabstandet sind und die jeweils über elektrische Leitungen 35 mit dem elektrischen Bauelement 3 verbunden sind. Die einer Ader (z.B. 11) des elektrischen Kabels 1 zugeordneten Anschlusselemente (z.B. 31) sind dabei im Ausführungsbeispiel entlang der Kabellängsrichtung L jeweils beidseits des elektrischen Bauelementes 3 angeordnet. Quer zu der Kabellängsrichtung L liegen die beiden zusammengehörenden, ein und derselben Ader (z.B. 11) zugeordneten Anschlusselemente jeweils auf derselben Höhe. Die zu unterschiedlichen Adern (z.B. 11 einerseits und 12 andererseits) gehörenden Anschlusselemente (z.B. 31 einerseits und 32 andererseits) sind im Ausführungsbeispiel jeweils quer zu der Kabellängsrichtung L auf unterschiedlicher Höhe angeordnet.

Die einzelnen Anschlusselemente 31, 32, 33, 34 bestehen aus einem elektrisch leitfähigen Material. Sie sind im Ausführungsbeispiel als (starre) Erhebungen auf dem flexiblen Träger 30, genauer auf dessen Innenseite I, ausgeführt. Weiterhin weisen die einzelnen Anschlusselemente 31, 32, 33, 34 jeweils Durchgänge 37 auf, die mit Durchgangsöffnungen 36 an dem flexiblen Träger 30 fluchten, wie anhand Figur 1D deutlich wird.

Bei dem am flexiblen Träger 30 angeordneten elektrischen Bauelement 3 kann es sich insbesondere um ein Halbleiter-Bauelement handeln. Das elektrische Bauelement 3 ist vorteilhaft ebenfalls flexibel, sodass es bei einem Rollen des flexiblen Trägers 30 ebenfalls um die Adern 11, 12, 13, 14 herumgelegt werden kann.

Hierbei erstreckt sich das elektrische Bauelement 3 im Ausführungsbeispiel sowohl entlang der Umfangsrichtung des im Querschnitt ringförmigen flexiblen Trägers 30 als auch entlang der Längsrichtung L jeweils nur über einen Teil der entsprechenden Ausdehnung des flexiblen Trägers 30. Alternativ kann sich aber das elektrische Bauelement 3 entlang der Umfangsrichtung und/oder entlang der Längsrichtung L über die gesamte entsprechende Ausdehnung des flexiblen Trägers 30 erstrecken.

In der perspektivischen Querschnittsdarstellung nach Figur 1D ist die Anordnung des vorstehend anhand der Figuren 2A bis 2D erläuterten flexiblen Trägers 30 an einem elektrischen Kabel 1 der in den Figuren 1A bis 1C gezeigten Art im Detail erkennbar.

Der flexible Träger 30 umschließt die Adern 11, 12, 13, 14 des elektrischen Kabels 1, wobei letztere im Ausführungsbeispiel in dem vom flexiblen Träger 30 umfassten Bereich teilweise von ihrer Isolierung einer 21, 22, 23 bzw. 24 befreit sind, sodass die von der Innenseite I des flexiblen Trägers 3 vorspringenden Anschlusselemente 31, 32, 33, 34 mit jeweils einer zugeordneten Ader 11, 12, 13, 14 in elektrischen Kontakt bringbar sind. Der Kontakt zwischen einem jeweiligen Anschlusselement 31, 32, 33, 34 und der zugeordneten (teilweise freigelegten) Ader 11, 12, 13, 14 des elektrischen Kabels 1 erfolgt dabei nicht unmittelbar; sondern er erfolgt (mittelbar) über einen jeweiligen Verbindungsbereich 31a, 32a, 33a, 34a, über welchen ein jeweiliges elektrisches Anschlusselement 31, 32, 33, 34 mit der zugeordneten Ader 11, 12, 13, 14 des elektrischen Kabels 1 verbunden ist.

Die Verbindungsbereiche 31a, 32a, 33a, 34a werden vorliegend gebildet durch stoffschlüssige Verbindungsstellen, z.B. in Form von Lötstellen. D.h., ein jeweiliges elektrisches Anschlusselement 31, 32, 33, 34 ist mit der zugeordneten Ader 11, 12, 13, 14 des elektrischen Kabels 1 über den jeweiligen Verbindungsbereich 31a, 32a, 33a, 34a stoffschlüssig verbunden, wobei die stoffschlüssige Verbindung im Ausführungsbeispiel als Lötverbindung ausgeführt ist (z.B. durch elektrisches Verlöten). Das Einbringen des Lotes erfolgt dabei durch die jeweilige Durchgangsöffnung 37 im flexiblen Träger 30 und den zugeordneten Durchgang 36 im jeweiligen Anschlusselement 31, 32, 33, 34 hindurch.

Als Material für das Lot kann z.B. Zinn vorgesehen sein. Als Material für die elektrischen Anschlusselemente 31-34 eignen sich beispielsweise Kupfer, Silber, Gold oder Zinn.

Anhand Figur 1D wird weiter deutlich, dass sich der flexible Träger 30 über die elektrischen Anschlusselemente 31, 32, 33, 34 (sowie die zugehörigen Verbindungsbereiche 31a, 32a, 33a, 34a) nach innen, d.h. in Richtung auf das Kabelinnere, an den Adern 11, 12, 13, 14 des elektrischen Kabels 1 (bzw. an deren abisolierten Abschnitten) abstützt.

Nach außen schließt sich an den flexiblen Träger in radialer Richtung ein Kabelschirm 4 an, der im Ausführungsbeispiel als eine Schirmfolie ausgebildet ist und der die Adern 11, 12, 13, 14 des elektrischen Kabels 1 nach Art einer Hülle im Querschnitt ringförmig umgibt. Der Kabelschirm 4 ist im Ausführungsbeispiel so ausgeführt, dass er auf seiner dem Kabelinneren zugewandten Seite nicht leitend ist. Hierdurch soll insbesondere ein elektrischer Kontakt mit den elektrischen Anschlusselementen 31, 33, 33, 34 sowie den zugehörigen Verbindungsbereichen 31a, 32a, 33a, 34a verhindert werden. Konkret kann der Kabelschirm 4 beispielsweise durch eine mit Metall beschichtete bzw. bedampfte Kunststofffolie gebildet sein, wobei die metallische Seite des Kabelschirms radial nach außen weist.

Die äußerste Schicht des elektrischen Kabels 1 bildet ein Kabelmantel 5, der das gesamte Kabel umschließt und eine (flexible) äußere Hülle hierfür bildet.

Das auf dem flexiblen Träger 30 bzw. dessen Innenseite I angeordnete elektrische Bauelement 3, vergleiche Figuren 2A bis 2D, ist in dem Querschnitt gemäß Figur 1D nicht erkennbar; es liegt außerhalb der gewählten Schnittebene.

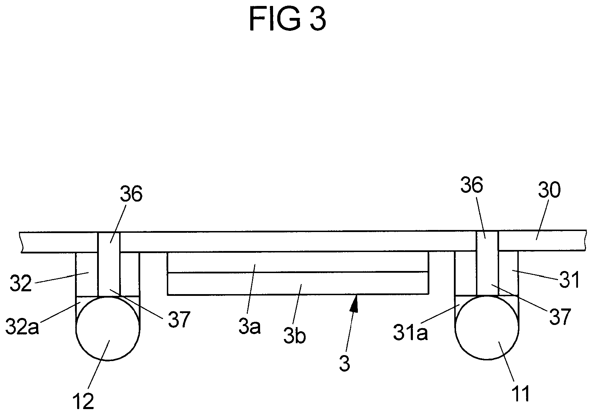

Figur 3 zeigt eine schematischen Schnitt durch den flexiblen Träger 30 im Bereich des elektrischen Bauelementes 3 sowie zweier Anschlusselemente 31, 32, wobei zwei Adern 11, 12 des elektrischen Kabels 1 und deren Verbindung mit den zugehörigen elektrischen Anschlussstellen 31, 32 ebenfalls erkennbar sind.

Gemäß Figur 3 besteht der flexible Träger 30 aus einer dünnen Trägerfolie, zum Beispiel in Form eines PVC-Filmes. Die Dicke des flexiblen Trägers 30 kann beispielsweise im Bereich zwischen 10 µm und 40 µm liegen.

Auf der den Adern 11, 12 des elektrischen Kabels 1 zugewandten Innenseite I des flexiblen Trägers 30 ist das elektrische Bauelement 3 aufgebracht. Dieses umfasst einen Chip 30a, der beispielsweise einen Träger aus Silizium sowie daran ausgebildete (geätzte) Halbleiterstrukturen aufweist. Hieran kann sich nach innen noch eine weitere (isolierende) Schicht 30b (nichtleitende Passivierungsschicht), zum Beispiel aus SiO₂ anschließen.

In Figur 3 ist ferner gezeigt, wie Adern 11, 12 des elektrischen Kabels 1 über die zugehörigen elektrischen Anschlussstellen 31, 32 sowie entsprechende Verbindungsbereiche 31a, 32a elektrisch kontaktiert und stoffschlüssig angebunden sind. Die Verbindungsbereiche 31a, 32a, zum Beispiel in Form jeweils eines Lotes, sind dabei durch hierfür vorgesehene Durchgangsöffnungen 36 am Träger 30 sowie hiermit fluchtende Durchgänge 37 an den elektrischen Anschlusselementen 31, 32 hindurch auf die Adern 11, 12 aufgebracht worden.

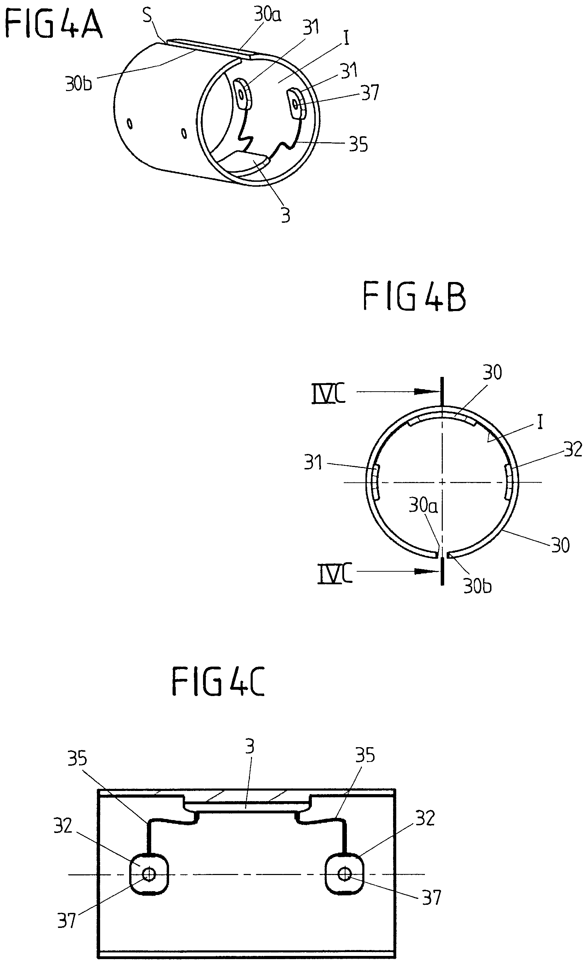

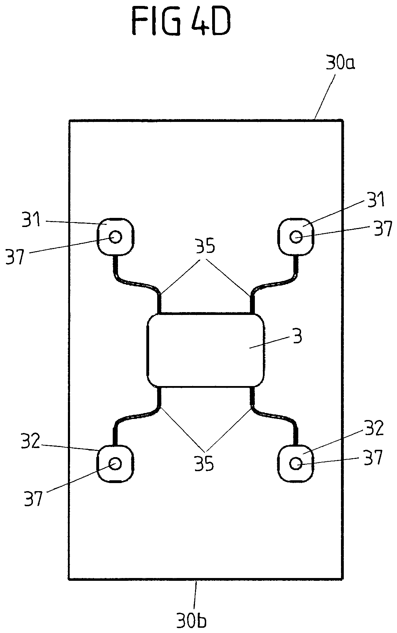

In den Figuren 4A bis 4D ist eine Abwandlung der Anordnung aus den Figuren 2A bis 2D dargestellt, wobei der wesentliche Unterschied darin besteht, dass beim Ausführungsbeispiel der Figuren 4A bis 4D jeweils nur zwei Paare 31 bzw. 32 elektrischer Anschlussstellen mit dem elektrischen Bauelement 3 verbunden sind - und nicht vier Paare 31, 32, 33, 34 wie im Fall der Figuren 2A bis 2D. Dementsprechend ist der in den Figuren 4A bis 4D gezeigte flexiblen Träger 30 mit dem hieran angeordneten elektrischen Bauelement 3 sowie den elektrische Anschlussstellen 31, 32 und zugehörigen Verbindungsleitungen (Leiterbahnen 35) vorgesehen zur elektrischen Kontaktierung eines Bauelementes 3 mit einem zweiadrigen elektrischen Kabel.

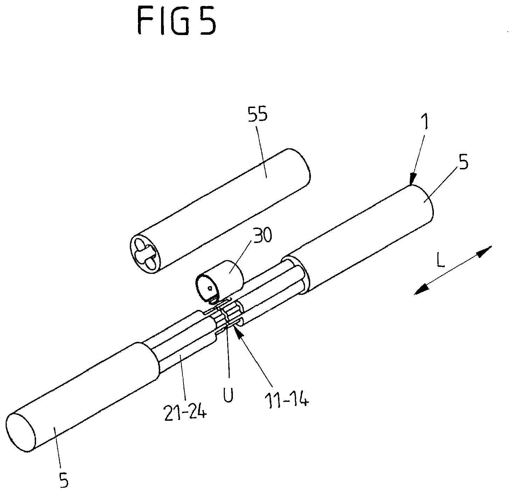

Figur 5 zeigt eine Abwandlung des elektrischen Kabels 1 aus den Figuren 1A bis 1D, wobei der wesentliche Unterschied darin besteht, dass gemäß Figur 5 der Kabelmantel 5 im Bereich des flexiblen Trägers 30 unterbrochen und durch eine Umspritzung 55 ersetzt ist, welche den flexiblen Träger 30 außen umgibt - sowie im Ausführungsbeispiel außerdem die axial (entlang der Kabellängsrichtung L) daran unmittelbar anschließenden Bereiche der Adern 11-14.

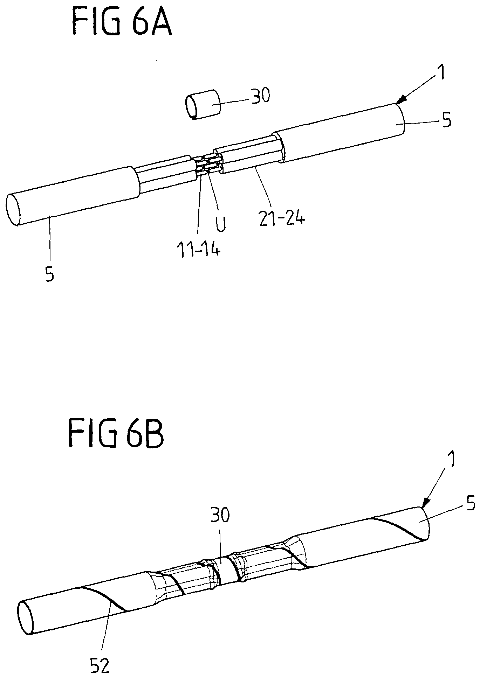

In den Figuren 6A und 6B ist eine weitere Abwandlung des elektrischen Kabels 1 aus den Figuren 1A bis 1D dargestellt. Bei der in den Figuren 6A und 6B gezeigten Ausführungsform eines elektrischen Kabels 1 ist auf die Außenseite des Kabelmantels 5 ein Band 52 als Isolator aufgebracht. Dabei überdeckt das Band 52 beispielhaft auch einen vom Kabelmantel 5 befreiten Bereich des elektrischen Kabels 1 in der Umgebung des flexiblen Trägers 30.

Zur Herstellung einer der Anordnungen gemäß den vorstehend beschriebenen Figuren 1A bis 6B wird der flexible Träger 30 zusammen mit dem elektrischen Bauelement 3 über die Adern 11, 12 - sowie ggf. 13, 14 - des betreffenden elektrischen Kabels 1 gerollt bzw. in bereits gerolltem Zustand über die Adern des elektrischen Kabels 1 geschoben (nachdem die Isolierung 21, 22 - sowie ggf. 23, 24 - der Adern in dem vom flexiblen Träger 30 zu umgreifenden Bereich zumindest teilweise entfernt worden ist, um eine elektrische Kontaktierung des elektrischen Bauelement des 3 zu ermöglichen; dieses teilweise Entfernen der Isolierung kann thermisch und/oder mechanisch erfolgen).

Zur elektrischen Kontaktierung (und gleichzeitig Verbindung) des elektrischen Bauelementes 3 mit den abisolierten Bereichen der Adern 11, 12 (sowie ggf. 13, 14) wird durch eine jeweilige Durchgangsöffnung 36 des flexiblen Trägers 3 sowie einen hiermit fluchtenden Durchgang 37 an dem jeweiligen elektrischen Anschlusselement 31, 32 (sowie ggf. 33, 34) hindurch eine Verbindung durch Löten, Schweißen oder einen Klebeprozess (mit elektrisch leitfähigem Kleber) hergestellt. Bei Bedarf kann der flexible Träger 30 und/oder das elektrische Bauelement 3 zusätzlich mit einer Vergussmasse, einer Klebemasse oder einer Umspritzung als Schutz versehen werden.

In weiteren Schritten werden der Kabelschirm 4 sowie der Kabelmantel 5 aufgebracht, letzterer z.B. durch Extrusion, durch Aufschrumpfen oder durch Spritzgießen.

Hierbei sind der flexible Träger 30 sowie das elektrische Bauelement 3 hinreichend flexibel, so dass sie auf einen ausreichend kleinen Radius zusammenrollbar sind, um die Adern 11, 12 (sowie ggf. 13, 14) des elektrischen Kabels 1 derart zu umschließen, dass sie zwischen jenen Adern und einem äußeren Kabelschirm 4 und/oder einem äußeren Kabelmantel 5 aufgenommen werden können.

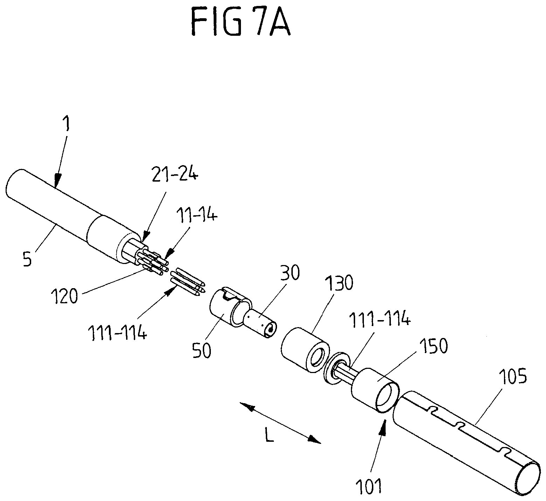

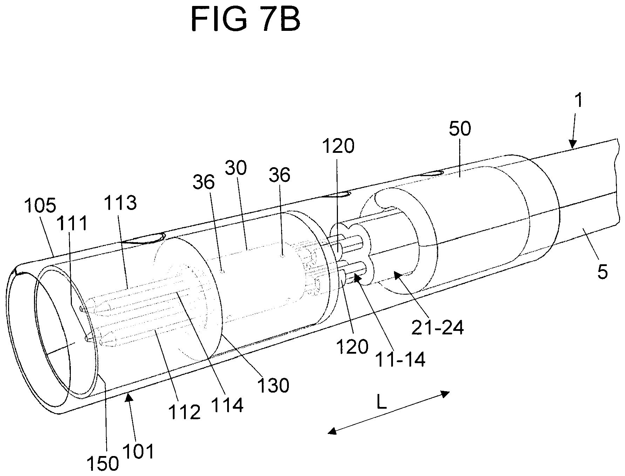

Die Figuren 7A und 7B zeigen eine Anwendung des vorstehend anhand der Figuren 2A bis 2D beschriebenen flexiblen Trägers 30 mit einem daran angeordneten elektrischen Bauelement 3 auf einen elektrischen Steckverbinder 101, der im Ausführungsbeispiel zur Konfektionierung eines elektrisches Kabels 1 dient. Hierbei handelt es sich beispielhaft um einen elektrischen Steckverbinder 101 mit insgesamt 4 Steckerelementen 111, 112, 113, 114, der dementsprechend als ein elektrischer Steckverbinder für ein vieradriges elektrisches Kabel 1 (mit vier Adern 11-14) vorgesehen ist.

Der Steckverbinder 101 ist mit dem elektrischen Kabel 1 verbunden und elektrisch kontaktiert, indem die Adern 11-14 des elektrischen Kabels 1 bzw. genauer die von der Isolierung 21-24 befreiten Enden der Adern 11, 12, 13, 14, jeweils mit einem der Steckerelemente 111, 112, 113, 114 des Steckverbinders 101 verbunden sind. Die Verbindung erfolgt dabei im Ausführungsbeispiel über Verbindungselemente 120, die jeweils eine der Adern 11-14 mit einem der Steckerelemente 111-114 verbinden und die hier beispielhaft als Crimpelemente ausgeführt sind.

Der Steckverbinder 101 weist zusätzlich zu den Steckerelementen 111, 112, 113, 114 einen Außenleiter 105 auf, der als eine Hülse ausgeführt ist und die Steckerelemente 111, 112, 113, 114 im Querschnitt ringförmig umgibt. Der Au ßenleiter 105 ist elektrisch mit dem Schirm 4 des elektrischen Kabels 1 verbunden; und er stützt sich im Ausführungsbeispiel über ein Stützelement 50, zum Beispiel in Form eines Stützcrimps, am elektrischen Kabel 1 ab

Zwischen den elektrischen Steckerelementen 111, 112, 113, 114 und dem Au ßenleiter 105 sind ein Schutzelement (Silikonschutz 130) sowie eine das Schutzelement 130 umgebende Umspritzung 150 angeordnet.

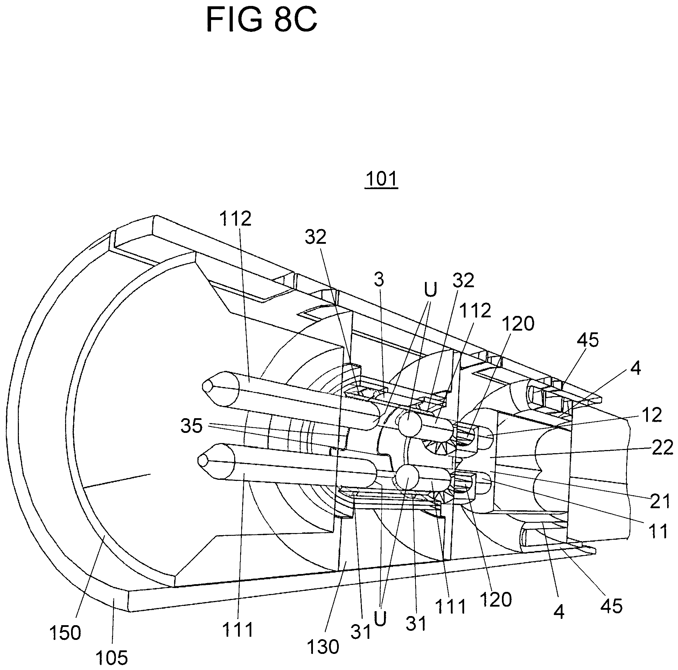

Die Steckerelemente 111-114 sind in axialer Richtung, also entlang ihrer Längserstreckungsrichtung, die vorliegend mit der Kabellängsrichtung L zusammenfällt, im Ausführungsbeispiel jeweils zweiteilig ausgeführt, d.h. ein jeweiliges Steckerelement 111, 112, 113 und 114 weist jeweils eine Unterbrechung U auf, vergleiche Figur 8C, sodass ein jeweiliges Steckerelement 111, 112, 113, 114 aus zwei separaten, entlang der Erstreckungsrichtung L hintereinander angeordneten und durch die besagte Unterbrechung U getrennten Teilelementen besteht.

Die Steckerelemente 111, 112, 113, 114 des elektrischen Steckverbinders 101 sind von einem flexiblen Träger 30 der anhand der Figuren 2A bis 2D dargestellten Art umgriffen. Wie anhand der Figuren 2A bis 2D beschrieben, weist der flexible Träger 30 auf seiner den Steckerelementen 111, 112, 113, 114 zugewandten Innenseite I ein elektrisches Bauelement 3 auf, das mit den besagten Steckerelementen in elektrischen Kontakt gebracht wird. Hierzu sind an dem flexiblen Träger 30 (auf dessen Innenseite I) elektrische Anschlusselemente 31, 32, 33, 34 vorgesehen, die jeweils über elektrische Leitungen (Leiterbahnen 35) mit dem elektrischen Bauelement 3 verbunden sind und die jeweils paarweise mit einem der Steckerelemente 111, 112, 113, 114 in elektrischem Kontakt stehen. Die Kontaktierung erfolgt im vorliegenden Ausführungsbeispiel in der Weise, dass durch das elektrische Bauelement 3 die vorstehend beschriebene Unterbrechung U der elektrischen Steckerelemente 111, 112, 113, 114 überbrückt wird.

In Figur 7B sind weiterhin die Durchgangsöffnungen 36 im flexiblen Träger 30 erkennbar, durch welche hindurch die Fixierung der elektrischen Anschlusselemente 31-34 an den elektrischen Steckerelementen 111, 112, 113, 114 erfolgt, insbesondere durch (elektrisches) Löten.

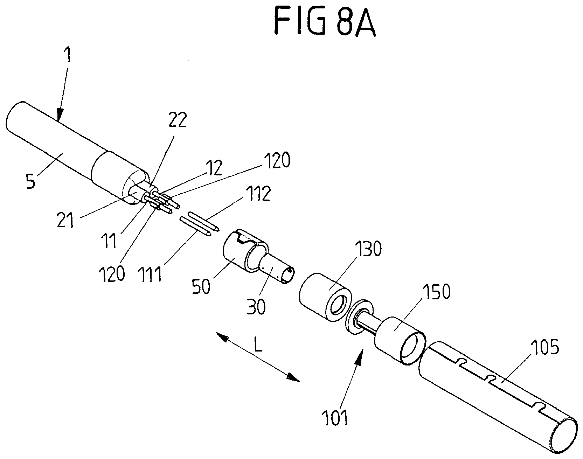

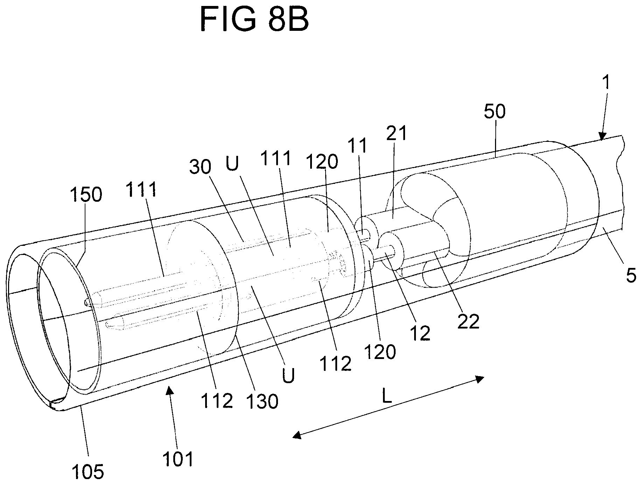

In den Figuren 8A und 8B ist eine Abwandlung der Anordnung aus den Figuren 7A und 7B (elektrischer Steckverbinder 101 mit zugehörigem elektrischen Kabel 1) dargestellt, wobei der Unterschied zu den Figuren 7A und 7B vor allem darin besteht, dass im Ausführungsbeispiel der Figuren 8A und 8B das elektrische Kabel 1 als ein zweiadriges elektrisches Kabel ausgeführt ist und dass der elektrischen Steckverbinder 101 dementsprechend zwei entlang der Längsrichtung L erstreckte Steckerelemente 111, 112 aufweist.

In der teilweise aufgebrochenen Darstellung der Figur 8C sind weitere Einzelheiten erkennbar, wie zum Beispiel das am flexiblen Träger 30 angeordnete elektrische Bauelement 3 sowie die jeweilige Unterbrechung U der elektrischen Steckerelemente 111, 112. Insbesondere zeigt die aufgebrochene Darstellung der Figur 8C, dass das elektrische Bauelement 3 über elektrische Leitungen (Leiterbahnen 35) mit zwei Paaren elektrischer Anschlusselemente 31, 32 in elektrischer Verbindung steht, welche jeweils auf der dem Steckerinneren zugewandten Innenseite des flexiblen Trägers 30 angeordnet sind und von welchen jedes Paar (31 oder 32) jeweils mit einem der elektrischen Steckerelemente 111, 112 in elektrischem Kontakt steht. Hierbei stützt sich der flexible Träger 30 gleichzeitig (über die elektrischen Anschlusselemente 31, 32) an den elektrischen Steckerelementen 111, 112 ab.

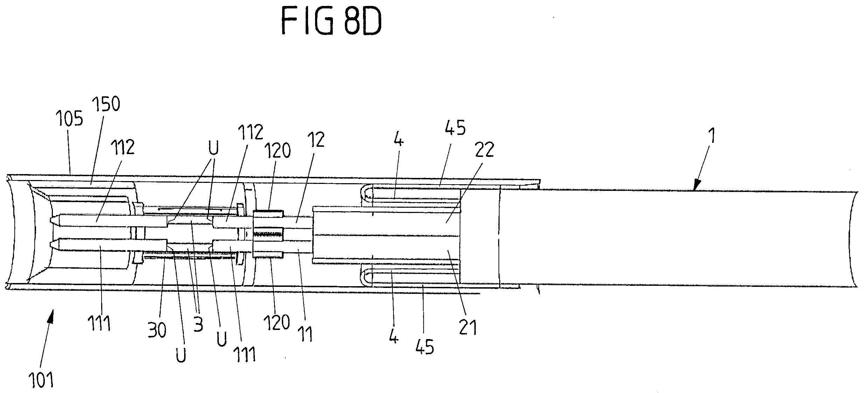

Aus Figur 8D ergibt sich, dass der Schirm 4 des elektrischen Kabels 1 an seinem steckerseitigen Endabschnitt 45 umgeschlagen ist. Über den umgeschlagenen steckerseitigen Endabschnitt 45 steht der Schirm 4 des elektrischen Kabels 1 in elektrischem Kontakt mit dem steckerseitigen Außenleiter 105. Dies erfolgt vorliegend in der Weise, dass der umgeschlagene Endabschnitt 40 des Kabelschirmes 4 den Außenleiter 105 untergreift und radial an dessen dem Steckerinneren zugewandter Innenwand anliegt.

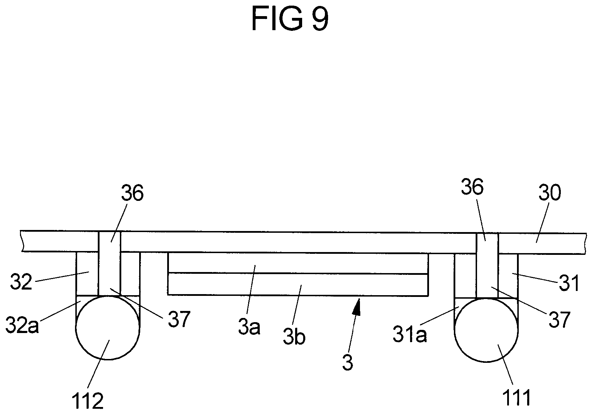

Die in Figur 9 gezeigte Schnittdarstellung eines Ausschnittes des flexiblen Trägers 30 im Bereich des elektrischen Bauelementes 3 entspricht im Wesentlichen der Darstellung gemäß Figur 3, wobei jedoch ein Unterschied darin besteht, dass Figur 3 das elektrische Bauelement 3 und den flexiblen Träger 30 zusammen mit den Adern 11, 12 eines elektrischen Kabels zeigt, während Figur 9 die Kontaktierung des elektrischen Bauelementes 3 mit Steckerelementen 111, 112 eines elektrischen Steckverbinders 101 betrifft.

Der flexible Träger 30 und das elektrische Bauelement 3 sind dabei so ausgeführt, wie vorstehend anhand Figur 3 beschrieben. Die elektrische Kontaktierung der zugehörigen Steckerelemente 111, 112 erfolgt jeweils über einen Verbindungsbereich 31a bzw. 32a, und zwar stoffschlüssig, zum Beispiel durch Löten, Schweißen oder Kleben. Zur Herstellung der Verbindung kann das erforderliche Verbindungsmaterial, zum Beispiel ein Lot, durch die jeweilige Durchgangsöffnung 36 des flexiblen Trägers 30 sowie den hiermit fluchtenden Durchgang 37 am jeweils zugeordneten Anschlusselement 31, 32 auf das entsprechende Steckerelement 111, 112 aufgebracht werden.

Das Versehen des Steckverbinders 101 mit einem (gerollten) flexiblen Träger 30 und einem innenseitig hieran angeordneten elektrische Bauelement 3 erfolgt in vergleichbarer Weise wie weiter oben für ein elektrisches Kabel 1 beschrieben. So wird der flexible Träger 30 zusammen mit dem hieran angeordneten elektrischen Bauelement 3 um die Steckerelemente 111, 112 - sowie ggf. 113, 114 - des Steckverbinders 101 gerollt bzw. im bereits gerollten Zustand hierauf aufgeschoben. Anschließend erfolgt die dauerhafte elektrischen Kontaktierung der trägerseitigen Anschlusselemente 31, 32 - sowie ggf. 33, 34 - mit den zugehörigen Steckerelementen, und zwar bevorzugt stoffschlüssig, wie zum Beispiel durch Löten, Schweißen oder Kleben. Das Einbringen des hierfür erforderlichen Materials an die Kontaktstellen geschieht durch die Durchgangsöffnungen 36 im flexiblen Träger 30 sowie durch die hiermit fluchtenden Durchgänge 37 an den Anschlusselementen 31, 32 (und ggf. 33, 34) hindurch.

Zudem werden die Kontaktelemente 111,112 (und ggf. 113, 114) abschnittsweise mit Kunststoff umspritzt. Ferner können der flexible Träger 30 und das hieran angeordnete elektrische Bauelement 3 außen mit einem Schutz versehen werden, zum Beispiel durch eine Verguss- oder Klebemasse oder durch eine Umspritzung aus Kunststoff.

Die Verbindung der Steckerelemente 111, 112 (und ggf. 113, 114) mit den Adern eines zweiadrigen elektrischen Kabels (STP) oder eines vierartigen elektrischen Kabels (STQ) kann durch Schweißen oder Crimpen erfolgen.

Als äußerste Schicht kann am Steckverbinder 101 noch ein Außenleiter 105, z.B. in Form einer metallischen Hülse, angeordnet werden. Diese kann wiederum in elektrischem Kontakt mit dem Schirm 4 des zugeordneten elektrischen Kabels 1 stehen.

## Patentansprüche

1. Elektrisches Kabel, mit
- mindestens zwei Adern (11-14), die nebeneinander entlang einer Kabellängsrichtung (L) verlaufen,
- einer Isolierung (21-24), mittels der die Adern (11-14) voneinander elektrisch isoliert sind, und
- einem elektrischen Bauelement (3), das mit den Adern (11-14) jeweils in elektrischem Kontakt steht,
**dadurch gekennzeichnet,**
**dass** das elektrische Bauelement (3) auf einem flexiblen Träger (30) angeordnet ist, der die Adern (11-14) im Querschnitt ringförmig umgibt, wobei das elektrische Bauelement (3) auf der den Adern (11-14) zugewandten Innenseite (I) des flexiblen Trägers (30) angeordnet ist und wobei die Isolierung (21-24) der Adern (11-14) an der Stelle, an der das elektrische Bauelement (3) angeordnet ist, teilweise beseitigt ist, um einen elektrischen Anschluss des elektrischen Bauelementes (3) zu ermöglichen.

2. Elektrisches Kabel nach Anspruch 1, **dadurch gekennzeichnet, dass** das elektrische Bauelement (3) als ein flexibles Halbleiter-Bauelement (3) ausgeführt ist.

3. Elektrisches Kabel nach Anspruch 1 oder 2, **dadurch gekennzeichnet, dass** auf dem flexiblen Träger (30) elektrische Leitungen (35) von dem elektrischen Bauelement (3) zu je einem elektrischen Anschlusselement (31-34) verlaufen, über das das elektrische Bauelement (3) mit den Adern (11-14) in elektrischem Kontakt steht

4. Elektrisches Kabel nach Anspruch 3, **dadurch gekennzeichnet, dass** die an dem Träger (30) angeordneten elektrischen Anschlusselemente (31-34) als starre, elektrische Verbindungsstellen ausgeführt sind, über die der flexible Träger (30) an den Adern (11-14) anliegen kann.

5. Elektrisches Kabel nach Anspruch 4, **dadurch gekennzeichnet, dass** die an dem flexiblen Träger (30) ausgebildeten elektrischen Anschlusselemente (31-34) als starre Erhebungen ausgeführt sind, die von dem Träger (30) in Richtung auf die Adern (11-14) abstehen.

6. Elektrisches Kabel nach einem der Ansprüche 3 bis 5, **dadurch gekennzeichnet, dass** die elektrischen Anschlusselemente (31-34) jeweils einen Durchgang (37) aufweisen, der mit einer zugeordneten Durchgangsöffnung (36) an dem flexiblen Träger (30) fluchtet.

7. Elektrische Kabel nach Anspruch 6, **dadurch gekennzeichnet, dass** der flexible Träger (30) durch die Durchgänge (37) an den Anschlusselementen (31-34) hindurch an den Adern (11-14) festgelegt ist.

8. Elektrisches Kabel nach Anspruch 7, **dadurch gekennzeichnet, dass** der flexible Träger (30) durch die Durchgänge (37) an den Anschlusselementen (31-34) hindurch stoffschlüssig an den Adern (11-14) festgelegt ist.

9. Elektrisches Kabel nach einem der Ansprüche 3 bis 8, **dadurch gekennzeichnet, dass** zur Kontaktierung jeder Ader (11-14) des elektrischen Kabels, die von dem flexiblen Träger (30) umschlossen ist, zwei entlang der Kabellängsrichtung (L) voneinander beabstandete Anschlusselemente (31-34) an dem flexiblen Träger (30) vorgesehen sind.

10. Elektrisches Kabel nach einem der vorhergehenden Ansprüche, **dadurch gekennzeichnet, dass** mindestens eine der Adern (11-14) an der Stelle, an der das elektrische Bauelement (3) angeordnet ist, eine Unterbrechung (U) aufweist, und dass die Unterbrechung (U) durch das elektrische Bauelement (3) überbrückt wird.

11. Elektrisches Kabel nach einem der vorhergehenden Ansprüche, **dadurch gekennzeichnet, dass** der flexible Träger (30) quer zur Kabellängsrichtung (L) ringförmig zusammengerollt ist, derart, dass dessen freie Enden (30a, 30b) einander gegenüber liegen.

12. Elektrisches Kabel nach Anspruch 11, **dadurch gekennzeichnet, dass** die Isolierung (21-24) der Adern (11-14) an der Stelle, an der das elektrische Bauelement (3) angeordnet ist, entlang der gesamten Längsausdehnung (I) des flexible Trägers (30) in Kabellängsrichtung (L) entfernt ist.

13. Elektrisches Kabel nach Anspruch 11 oder 12, **dadurch gekennzeichnet, dass** sich der flexible Träger (30) nach innen an den abisolierten Bereichen der Adern (11-14) abstützt.

14. Elektrisches Kabel nach einem der vorhergehenden Ansprüche, **dadurch gekennzeichnet, dass** die Längsausdehnung (I) des flexiblen Trägers (30) entlang der Kabellängsrichtung (L) weniger als 10% der Längsausdehnung des elektrischen Kabels beträgt.

15. Elektrisches Kabel nach einem der vorhergehenden Ansprüche, **dadurch gekennzeichnet, dass** die Adern (11-14) außen von einem Kabelschirm (4) umgeben sind und dass der der flexible Träger (30) zwischen den Adern (11-14) und dem Kabelschirm (4) angeordnet ist.

## Claims

1. Electric cable, comprising
- at least two wires (11-14), which extend beside one another along a cable longitudinal direction (L),
- insulation (21-24), by means of which the wires (11-14) are insulated electrically from one another, and
- an electric component (3), which is in respective electric contact with the wires (11-14),
**characterized in that**
the electric component (3) is arranged on a flexible carrier (30), which surrounds the wires (11-14) annularly in cross section, wherein the electric component (3) is arranged on the inner side (I) of the flexible carrier (30), facing the wires (11-14), and wherein the insulation (21-24) of the wires (11-14) is partly removed at the point at which the electric component (3) is arranged, in order to permit an electric connection to the electric component (3).

2. Electric cable according to Claim 1, **characterized in that** the electric component (3) is designed as a flexible semiconductor component (3).

3. Electric cable according to Claim 1 or 2, **characterized in that** on the flexible carrier (30), electric lines (35) extend from the electric component (3) to each electric connecting element (31-34), via which the electric component (3) is in electric contact with the wires (11-14).

4. Electric cable according to Claim 3, **characterized in that** the electric connecting elements (31-34) arranged on the carrier (30) are designed as rigid electric connection points, via which the flexible carrier (30) can rest on the wires (11-14).

5. Electric cable according to Claim 4, **characterized in that** the electric connecting elements (31-34) formed on the flexible carrier (30) are designed as rigid elevations, which protrude from the carrier (30) in the direction of the wires (11-14).

6. Electric cable according to one of Claims 3 to 5, **characterized in that** the electric connecting elements (31-34) each have a passage (37), which is aligned with the associated passage opening (36) on the flexible carrier (30).

7. Electric cable according to Claim 6, **characterized in that** the flexible carrier (30) is fixed to the wires (11-14) through the passages (37) on the connecting elements (31-34).

8. Electric cable according to Claim 7, **characterized in that** the flexible carrier (30) is firmly bonded to the wires (11-14) through the passages (37) on the connecting elements (31-34).

9. Electric cable according to one of Claims 3 to 8, **characterized in that** to make contact with each wire (11-14) of the electric cable which is enclosed by the flexible carrier (30), two connecting elements (31-34) spaced apart from each other along the cable longitudinal direction (L) are provided on the flexible carrier (30).

10. Electric cable according to one of the preceding claims, **characterized in that** at least one of the wires (11-14) has a discontinuity (U) at the point at which the electric component (3) is arranged, and **in that** the discontinuity (U) is bridged by the electric component (3).

11. Electric cable according to one of the preceding claims, **characterized in that** the flexible carrier (30) is rolled together annularly transversely to the cable longitudinal direction (L) in such a way that its free ends (30a, 30b) lie opposite each other.

12. Electric cable according to Claim 11, **characterized in that** the insulation (21-24) of the wires (11-14) is removed along the entire longitudinal extent (I) of the flexible carrier (30) in the cable longitudinal direction (L) at the point at which the electric component (3) is arranged.

13. Electric cable according to Claim 11 or 12, **characterized in that** the flexible carrier (30) is supported inwardly on the stripped regions of the wires (11-14).

14. Electric cable according to one of the preceding claims, **characterized in that** the longitudinal extent (I) of the flexible carrier (30) along the cable longitudinal direction (L) is less than 10% of the longitudinal extent of the electric cable.

15. Electric cable according to one of the preceding claims, **characterized in that** the wires (11-14) are surrounded on the outside by a cable screen (4), and **in that** the flexible carrier (30) is arranged between the wires (11-14) and the cable screen (4).

## Revendications

1. Câble électrique, comprenant
- au moins deux brins (11 à 14) qui s'étendent les uns à côté des autres le long d'une direction longitudinale de câble (L),
- une isolation (21 à 24) au moyen de laquelle les brins (11 à 14) sont électriquement isolés les uns par rapport aux autres, et
- un composant électrique (3) qui est en contact électrique respectivement avec les brins (11 à 14),
**caractérisé en ce que** le composant électrique (3) est disposé sur un support flexible (30) qui entoure les brins (11 à 14) en forme d'anneau en section transversale, le composant électrique (3) étant disposé sur le côté intérieur (I) du support flexible (30), tourné vers les brins (11 à 14), et l'isolation (21 à 24) des brins (11 à 14) étant partiellement bilatérale à l'endroit où est disposé le composant électrique (3) afin de permettre un raccordement électrique du composant électrique (3).

2. Câble électrique selon la revendication 1, **caractérisé en ce que** le composant électrique (3) est réalisé sous la forme d'un composant semiconducteur flexible (3).

3. Câble électrique selon la revendication 1 ou 2, **caractérisé en ce que** sur le support flexible (30), des lignes électriques (35) s'étendent du composant électrique (3) jusqu'à respectivement un élément de raccordement électrique (31 à 34) par lequel le composant électrique (3) est en contact électrique avec les brins (11 à 14).

4. Câble électrique selon la revendication 3, **caractérisé en ce que** les éléments de raccordement électrique (31 à 34) disposés sur le support (30) sont réalisés sous forme de points de jonction électrique rigides par lesquels le support flexible (30) peut être appliqué aux brins (11 à 14).

5. Câble électrique selon la revendication 4, **caractérisé en ce que** les éléments de raccordement électrique (31 à 34) réalisés sur le support flexible (30) sont réalisés sous la forme de bosses rigides qui font saillie à partir du support (30) en direction des brins (11 à 14).

6. Câble électrique selon l'une quelconque des revendications 3 à 5, **caractérisé en ce que** les éléments de raccordement électrique (31 à 34) présentent respectivement un passage (37) qui est en alignement avec une ouverture traversante (36) associée sur le support flexible (30).

7. Câble électrique selon la revendication 6, **caractérisé en ce que** le support flexible (30) est immobilisé sur les brins (11 à 14) à travers les passages (37) sur les éléments de raccordement (31 à 34).

8. Câble électrique selon la revendication 7, **caractérisé en ce que** le support flexible (30) est immobilisé sur les brins (11 à 14) par liaison de matière à travers les passages (37) sur les éléments de raccordement (31 à 34).

9. Câble électrique selon l'une quelconque des revendications 3 à 8, **caractérisé en ce que** pour la mise en contact de chaque brin (11 à 14) du câble électrique, qui est entouré par le support flexible (30), deux éléments de raccordement (31 à 34) espacés l'un de l'autre le long de la direction longitudinale de câble (L) sont prévus sur le support flexible (30).

10. Câble électrique selon l'une quelconque des revendications précédentes, **caractérisé en ce qu'**au moins l'un des brins (11 à 14) présente à l'endroit où est disposé le composant électrique (3) une rupture (U), et **en ce que** la rupture (U) est pontée par le composant électrique (3).

11. Câble électrique selon l'une quelconque des revendications précédentes, **caractérisé en ce que** le support flexible (30) est enroulé en forme d'anneau transversalement à la direction longitudinale de câble (L) de telle sorte que ses extrémités libres (30a, 30b) sont opposées l'une à l'autre.

12. Câble électrique selon la revendication 11, **caractérisé en ce que** l'isolation (21 à 24) des brins (11 à 14) est retirée à l'endroit où est disposé le composant électrique (3) sur toute l'étendue longitudinale (I) du support flexible (30) dans la direction longitudinale de câble (L).

13. Câble électrique selon la revendication 11 ou 12, **caractérisé en ce que** le support flexible (30) prend appui vers l'intérieur sur les zones dénudées des brins (11 à 14).

14. Câble électrique selon l'une quelconque des revendications précédentes, **caractérisé en ce que** l'étendue longitudinale (I) du support flexible (30) le long de la direction longitudinale de câble (L) est inférieure à 10 % de l'étendue longitudinale du câble électrique.

15. Câble électrique selon l'une quelconque des revendications précédentes, **caractérisé en ce que** les brins (11 à 14) sont entourés à l'extérieur par un blindage de câble (4), et **en ce que** le support flexible (30) est disposé entre les brins (11 à 14) et le blindage de câble (4).
